(19) Europäisches Patentamt
European Patent Office
Office européen des brevets

(11) **EP 2 937 117 B1**

(12) **FASCICULE DE BREVET EUROPEEN**

(45) Date de publication et mention
de la délivrance du brevet:
**09.11.2016 Bulletin 2016/45**

(51) Int Cl.:
*A63B 24/00* ^(2006.01)    *A63B 51/02* ^(2015.01)
*A63B 69/38* ^(2006.01)    *H02N 2/18* ^(2006.01)
*A63B 49/08* ^(2015.01)

(21) Numéro de dépôt: **15164167.7**

(22) Date de dépôt: **20.04.2015**

(54) **RAQUETTE A CORDAGE PIEZOELECTRIQUE**

SCHLÄGER MIT PIEZOELEKTRISCHER BESAITUNG

RACQUET WITH PIEZOELECTRIC STRINGS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **25.04.2014 FR 1453766**

(43) Date de publication de la demande:
**28.10.2015 Bulletin 2015/44**

(73) Titulaire: **COMMISSARIAT A L'ENERGIE
ATOMIQUE ET AUX
ENERGIES ALTERNATIVES
75015 Paris (FR)**

(72) Inventeurs:
• **Savelli, Guillaume**
**38000 GRENOBLE (FR)**
• **Coronel, Philippe**
**38530 BARRAUX (FR)**

(74) Mandataire: **Cabinet Laurent & Charras
Le Contemporain
50 Chemin de la Bruyère
69574 Dardilly Cedex (FR)**

(56) Documents cités:
**DE-A1- 2 942 533    US-A- 4 257 594**

## Description

### DOMAINE DE L'INVENTION

L'invention a trait au domaine des raquettes à cordage, notamment les raquettes de tennis et de badminton.

### ETAT DE LA TECHNIQUE

Les matériaux piézoélectriques permettent aujourd'hui d'envisager des applications multiples dans le domaine du sport, et notamment dans le domaine des raquettes dites « intelligentes ». Ces matériaux permettent en effet de convertir une énergie mécanique en énergie électrique et vice versa. Par exemple, la société Head Tyrolia Mares a conçu une raquette dont le cadre comprend des fibres piézoélectriques et des capteurs de vibration connectés à une puce électronique. Les capteurs mesurent les vibrations du cadre de la raquette sous l'effet d'une frappe de balle et transmettent cette information à la puce électronique. Cette dernière détermine en fonction de celle-ci une vibration contraire du cadre et commande les fibres piézoélectriques du cadre pour que celles-ci appliquent la vibration contraire, neutralisant ainsi les vibrations premières générés par la frappe de la balle. Il en résulte ainsi un cadre de raquette plus rigide, ce qui constitue un moyen de lutter contre le tennis-elbow, une inflammation fréquemment constatée chez 60% des joueurs réguliers.

L'une des principales difficultés d'un débutant de sport de raquette à cordage, par exemple le tennis, est de centrer la balle par rapport à la raquette au moment de la frappe, que cela soit en coup droit ou en revers. En effet, le débutant éprouve des difficultés à déterminer si sa balle est bien centrée tant il est en tout premier lieu préoccupé à renvoyer la balle. Pour les joueurs confirmés, avoir des statistiques concernant la répartition de ses frappes sur le cordage d'une raquette, en combinaison le cas échéant de la puissance de ses frappes, permet par exemple de travailler son placement et d'affiner sa technique de frappe. A l'heure actuelle, ces informations ne sont déterminées qu'au jugé, par le joueur lui-même ou par un entraineur, et sont donc très incomplètes.

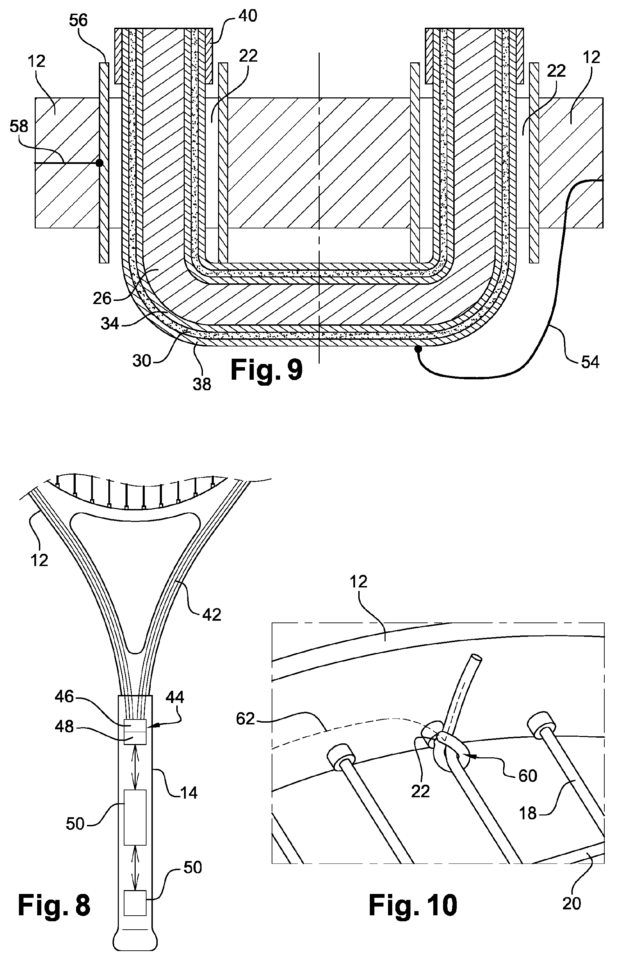

US 4 257 594 A divulgue un système comprenant une raquette ayant un manche, un cadre fixé au manche et un cordage comprenant au moins deux cordes perpendiculaires tendues dans le cadre, chaque corde réalisant des allers-retours dans le cadre en passant par des ouvertures formées dans celui-ci, tel que le système comporte (voir fig. 9): - pour chaque corde (14), deux fils (130, 132) enroulés autour de la corde et connectés avec un élément piézoélectrique (134) ; et - un circuit électronique (fig. 10) connecté aux zones piézoélectriques des fils enroulés autour des cordes pour identifier une portion du cordage subissant les plus fortes contraintes mécaniques en fonction des tensions générées par les zones piézoélectriques des cordes.

### EXPOSE DE L'INVENTION

Le but de la présente invention est de proposer un système permettant de déterminer la position de la balle sur le cordage d'une raquette lors de la frappe.

A cet effet, l'invention a pour objet un système comprenant une raquette ayant un manche, un cadre fixé au manche et un cordage comprenant deux cordes perpendiculaires tendues dans le cadre, chaque corde réalisant des allers retours dans le cadre en passant par des ouvertures formées dans celui-ci.

Selon l'invention, le système comporte:

- pour chaque corde, une gaine piézoélectrique enrobant ladite corde sur l'essentiel de sa longueur, ladite gaine étant divisée sur sa longueur en au moins trois zones piézoélectriques comprenant chacune une couche piézoélectrique intercalée entre deux couches conductrices formant respectivement une première et une seconde électrodes, la couche piézoélectrique et au moins une des électrodes de chaque zone piézoélectrique formant un ensemble électriquement isolé des couches piézoélectriques et des électrodes des autres zones piézoélectriques de sorte que chaque zone piézoélectrique génère entre ses électrodes une tension indépendante en fonction de contraintes mécaniques exercées sur le cordage ;

- un circuit électronique connecté aux zones piézoélectriques des cordes pour identifier une portion du cordage subissant les plus fortes contraintes mécaniques en fonction des tensions générées par les zones piézoélectriques des cordes.

Pour des soucis de clarté, et conformément aux figures décrites ci-après, l'axe principal du manche de la raquette est qualifié de « vertical », et un axe perpendiculaire à l'axe principal du manche de la raquette est qualifié d' « horizontal ». De même, par souci de concision, il est fait référence à une balle, bien que ce terme s'applique à tout type d'objet, par exemple un volant dans le cadre d'une raquette de badminton.

Comme cela est connu en soi, un cordage de raquette consiste en deux cordes perpendiculaires, verticale (ou « montant ») et horizontale (ou « travers »), entrelacées et tendues sur un cadre en faisant des allers retours. En divisant chaque corde en zones piézoélectriques successives, chacune capable de générer une tension en fonction de contraintes mécaniques exercées sur sa couche piézoélectrique, par exemple en trois zones, et en raison des allers-retours de la corde sur le cadre, les trois zones piézoélectriques de la corde divisent en trois surfaces distinctes le cordage de la raquette, chacune des surfaces étant associée à une tension. Par exemple, concernant la corde verticale, cette disposition induit une division verticale de la surface du cordage en trois zones. De même, pour la corde horizontale, la surface du cordage est divisée horizontalement en trois zones. Une matrice de trois colonnes et trois lignes, comprenant une zone centrale, est donc ainsi définie, chacune des zones étant associées à un couple distinct de tensions délivrées par les zones piézoélectriques des cordes.

Le circuit électronique, avantageusement partiellement ou en totalité logé dans le manche de la raquette, récupère les tensions générées par les zones piézoélectriques et identifie en fonction de celles-ci la zone du cordage ayant frappé la balle. Cette information peut être ensuite utilisée à des fins statistiques et/ou affichée, avantageusement en temps réel, sur un écran à destination du joueur ou d'un entraineur.

Selon un mode de réalisation, la gaine de chaque corde comprend :

- une première couche continue et électriquement conductrice, formée sur l'essentiel de la longueur de la corde, la première couche constituant la première électrode de chaque zone piézoélectrique de la corde ;
- au moins trois portions de couche piézoélectrique, déposées sur la première couche ; et
- des secondes couches électriquement conductrices distinctes, déposées respectivement sur les couches piézoélectriques et formant respectivement les secondes électrodes des zones piézoélectriques.

Selon un mode de réalisation, la gaine de chaque corde comprend une couche externe de protection électriquement isolante. Plus particulièrement, la couche externe est partiellement dénudée sur une portion en regard de chaque zone piézoélectrique de la corde, ladite portion dénudée étant sur le cadre, de manière à libérer une portion de la seconde couche de ladite zone. Notamment, le système comprend des connexions électriques agencées sur ou dans le cadre et soudées respectivement aux portions libérées des secondes couches de manière à collecter la tension générée par ladite zone. En particulier, les connexions électriques se prolongent dans le manche, et le circuit électronique est au moins partiellement logé dans le manche et est connecté aux connexions électriques.

Selon un mode de réalisation, le circuit électronique est entièrement compris dans le manche. Notamment, le circuit électronique comprend une mémoire informatique pour stocker des informations relatives aux portions de cordage identifiées et un circuit d'émission sans fil connecté à ladite mémoire pour transmettre par une liaison de communication sans fil lesdites informations à l'extérieur du manche.

Selon un mode de réalisation, le circuit électronique comporte un élément de stockage d'énergie électrique pour stocker l'énergie électrique générée par les zones piézoélectriques. Notamment, l'élément de stockage de l'énergie électrique comporte une micro-batterie formée sur un substrat souple ou rigide et/ou une capacité et/ou une supercapacité ou piles boutons.

## BREVE DESCRIPTION DES FIGURES

L'invention sera mieux comprise à la lecture de la description qui va suivre, donnée uniquement à titre d'exemple, et réalisée en relation avec les dessins annexés dans lesquels :

- la figure 1 est une vue de dessus d'une raquette de tennis de l'état de la technique ;
- la figure 2 est une vue en coupe de détail de la raquette de la figure 1 selon le plan du cordage de celle-ci ;
- la figure 3 est une vue schématique d'une corde selon l'invention ;
- la figure 4 est une vue en coupe selon le plan IV-IV de la figure 3, illustrant un mode de réalisation d'une zone piézoélectrique entrant dans la constitution de la corde ;
- la figure 5 est une vue schématique en coupe selon le plan V-V de la figure 3, illustrant une zone intermédiaire entre deux zones piézoélectriques entrant dans la constitution de la corde ;
- les figures 6 et 7 sont des vues schématiques des divisions du cordage de la raquette induites par les cordes selon l'invention, et les tensions associées à ces divisions générées par les zones piézoélectriques ;
- la figure 8 est une vue schématique des connexions électriques aux zones piézoélectriques et d'un circuit électronique de traitement des tensions générées par les zones piézoélectriques ;
- la figure 9 est une vue schématique en coupe illustrant la reprise de contact pour la connexion d'une zone piézoélectrique en vue de collecter la tension générée par celle-ci ; et
- la figure 10 est une vue schématique en perspective illustrant la reprise de contact vers une masse électrique d'une corde de la raquette.

## DESCRIPTION DETAILLEE DE L'INVENTION

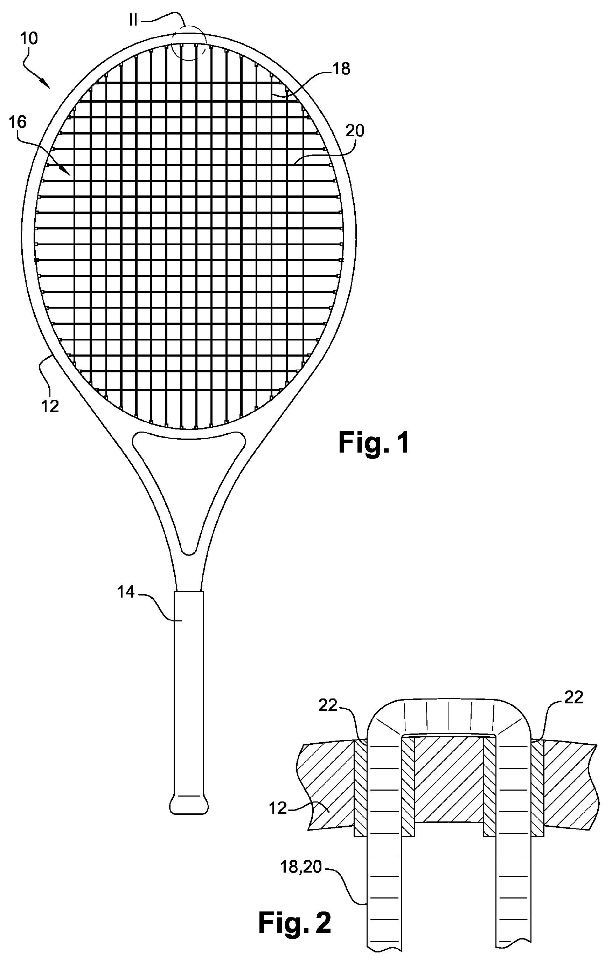

Sur la figure 1, une raquette de tennis **10** comprend un cadre **12** se prolongeant par un manche **14,** ainsi qu'un cordage **16** tendu dans le cadre **12.** Le cordage comprend une corde de tennis verticale **18,** ou « montant », entrelacée avec une corde de tennis horizontale **20,** ou « travers ». Comme illustré à la vue de détail de la figure 2, chaque corde **18, 20** fait des allers-retours dans le cadre **12,** en passant par des ouvertures **22** formées dans celui-ci, et se termine à chacune de ses extrémités par un noeud pour son maintien en place dans le cadre **12.** L'agencement venant d'être décrit est bien connu de l'état de la technique du domaine des raquettes de tennis, et ne sera donc pas décrit plus en détail pour des raisons de concision.

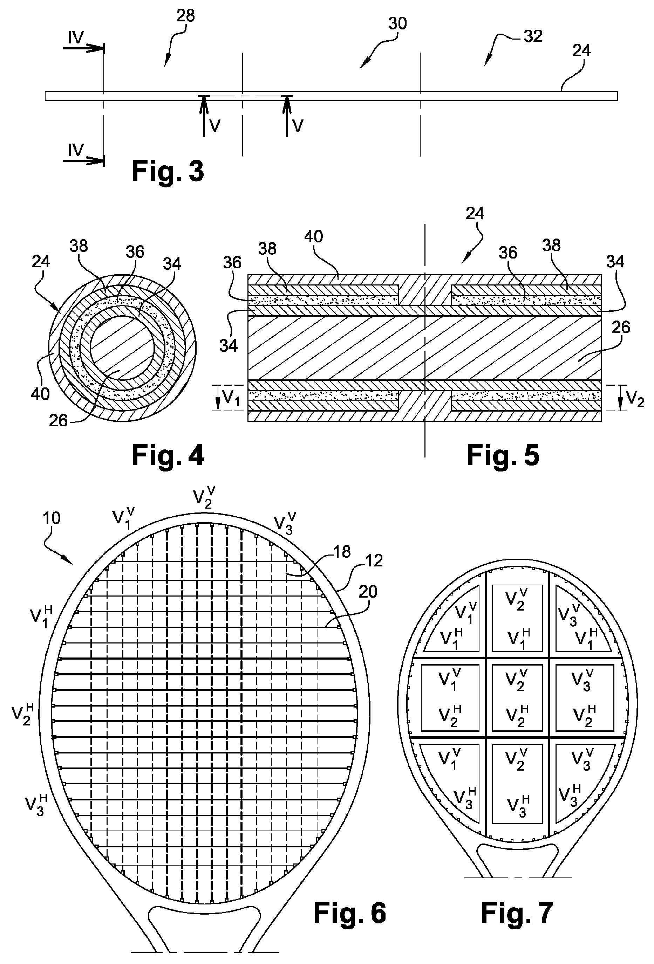

Chaque corde **18, 20** est en outre enrobée d'une gaine piézoélectrique sur toute sa circonférence et sur l'essentiel de sa longueur. Comme illustrée aux figures 3 à 5, la gaine **24** enrobe une âme centrale **26,** telle qu'une corde de tennis de l'état de la technique, et est divisée en trois zones piézoélectriques **28, 30, 32** de structure et de dimensions identiques.

En se référant à la figure 4, chacune des zones **28, 30, 32** comprend :

- une première couche métallique **34,** enrobant l'âme centrale **26** sur toute la longueur et toute la circonférence de celle-ci, la première couche métallique **34** formant une première électrode commune à l'ensemble des zones **28, 30, 32** ;
- une couche de matériau piézoélectrique **36,** enrobant la première couche métallique **34** sur toute la circonférence et sur une portion de la longueur de celle-ci ;
- une seconde couche métallique **38,** enrobant la couche de matériau piézoélectrique **36** sur toute la longueur et toute la circonférence de celle-ci, la seconde couche métallique **36** formant une deuxième électrode pour la zone piézoélectrique ; et
- une couche de protection mécanique et électrique, notamment isolante, externe **40,** enrobant l'ensemble de la corde sur toute la circonférence et sur l'essentielle de la longueur de la corde **18, 20.**

La couche piézoélectrique **36** libère des charges électriques lorsqu'elle se déforme, et donc libère des charges électriques sous l'effet d'une frappe de balle par la raquette **10.** La couche de matériau piézoélectrique est avantageusement un film de polyfluorure de vinylidène ou de titano-zirconate de plomb, qui présente l'avantage d'être à la fois léger, souple et mécaniquement résistant. En variante, la couche **36** est constituée de titano-zirconate de plomb (« PZT »), d'oxyde de zinc (« ZnO »), ou d'un matériau composite d'au moins deux matériaux parmi ceux-ci et le PVDF. Notamment, la couche piézoélectrique a une épaisseur comprise entre 10 nanomètres et 500 micromètres. Les couches métalliques **34, 38** ont une épaisseur comprise entre 1 nanomètre à 100 micromètres chacune, et sont constituées par exemple d'argent, de nitrure de cuivre, d'aluminium. La couche de protection mécanique est quant à elle constituée par exemple d'un oxyde, notamment du $SiO_2$, ou du $Si_2N_4$ d'une épaisseur comprise entre 100 nanomètres et 1 millimètres. Les différentes couches de la gaine **24** sont par exemple réalisées par un dépôt chimique ou physique en phase vapeur, par une technique d'impression, par exemple par pulvérisation ou par dépôt à la tournette (« spin coating »), ou autre.

Comme illustré à la figure 5, les zones piézoélectriques sont agencées électriquement de manière à ce que l'empilement des couches métalliques **34, 38** et de la couche piézoélectrique **36** de chacune des zones génère une tension indépendante sous l'effet de contraintes mécaniques subies. Notamment, la couche piézoélectrique **36** et la deuxième couche métallique **38** d'une zone sont isolées électriquement des couches piézoélectriques et des deuxièmes couches métalliques des autres zones. Ainsi sur la figure 5, sous l'effet de contraintes mécaniques, il s'établit une tension V1 entre la couche métallique **34** et la couche métallique **38** de la zone piézoélectrique illustrée à gauche et il s'établit une tension V2 entre la couche métallique **34** et la couche métallique **38** de la zone piézoélectrique illustrée à droite, les tensions V1 et V2 étant indépendantes l'une de l'autre, la couche **34** servant de masse à l'ensemble des zones piézoélectriques. Ainsi, chaque zone piézoélectrique **28, 30, 32** de la corde génère une tension électrique qui lui est propre en fonction des contraintes mécaniques que sa couche piézoélectrique subit.

En se référant à la figure 6, qui illustre le cordage de la raquette **10** avec les différentes zones piézoélectriques, les allers-retours des cordes **18, 20** dans le cadre **12** ont pour effet de diviser la surface du cordage :

- en trois portions verticales distinctes, associées respectivement aux tensions uniques $V_1^V$, $V_2^V$, $V_3^V$ générées par les zones piézoélectriques de la corde verticale **18 ;** et
- et en trois portions horizontales distinctes, associées respectivement aux tensions uniques $V_1^H$, $V_2^H$, $V_3^H$ générées par les zones piézoélectriques de la corde horizontale **20.**

La surface du cordage de la raquette **10** est donc divisée en une matrice de trois colonnes et trois lignes de portions de cordage, chaque portion de référence *(i, j)* dans la matrice étant associée à un couple de tensions unique $\left( V_i^H, V_j^V \right)$.

En se référant à la figure 8, l'ensemble des tensions $V_1^V$, $V_2^V$, $V_3^V$, $V_1^H$, $V_2^H$, $V_3^H$ générées par les zones piézoélectriques des cordes **18, 20** sont collectées par des connexions électriques **42** logées sur ou dans le cadre **12,** et délivrées à un circuit électronique **44** logé dans le manche **14** de la raquette **10.** Le circuit électronique **44** détermine en fonction de ces tensions quelle portion de cordage de la matrice à fait l'objet d'une frappe de balle. A cet effet, le circuit comporte par exemple un convertisseur analogique-numérique **46** pour numériser les tensions $V_1^V$, $V_2^V$, $V_3^V$, $V_1^H$, $V_2^H$, $V_3^H$ et une unité de traitement numérique **48,** par exemple un microcontroleur, mettant en oeuvre un traitement des tensions numérisées $\hat{V}_1^V$, $\hat{V}_2^V$, $\hat{V}_3^V$, $\hat{V}_1^H$, $\hat{V}_2^H$, $\hat{V}_3^H$ pour identifier la portion de cordage - objet de la frappe, et une mémoire informatique pour stocker des informations relatives à cette identification. Le circuit **44** comporte en outre un module pour transférer lesdites informations à l'extérieur du manche, avantageusement au moyen d'une connexion sans fil, par exemple du type radiofréquence.

Selon un mode de réalisation de l'invention, l'unité de traitement numérique **48** met en oeuvre :

- un premier module logiciel pour identifier les maxima $P_1^V$, $P_2^V$, $P_3^V$, $P_1^H$, $P_2^H$, $P_3^H$ respectif des tensions numérisées $\hat{V}_1^V$, $\hat{V}_2^V$, $\hat{V}_3^V$, $\hat{V}_1^H$, $\hat{V}_2^H$, $\hat{V}_3^H$ reçues ; et
- un deuxième module logiciel pour identifier la portion de cordage en fonction des couples $\left( P_i^H, P_j^V \right)$ de maxima identifiés $P_1^V$, $P_2^V$, $P_3^V$, $P_1^H$, $P_2^H$, $P_3^H$.

En particulier, suite à la frappe d'une balle, des tensions sont générées de manière synchrone par l'ensemble des zones piézoélectriques des cordes **18, 20.** En outre, en raison de la pratique usuelle en matière de sports de raquette, les frappes sont espacées dans le temps de plusieurs secondes, de sorte que les tensions résultant d'une frappe de balle sont temporellement distinctes des tensions générées lors d'autres frappes de balle. En conséquence, le circuit électronique reçoit des ensembles de tensions synchrones $V_1^V$, $V_2^V$, $V_3^V$, $V_1^H$, $V_2^H$, $V_3^H$ sous la forme de train d'impulsions de tensions et peut donc aisément identifier le maximum de chaque tension reçue d'une manière connue en soi de l'état de la technique. La portion de cordage ayant servi à frapper une balle produisant des tensions supérieures aux tensions des autres portions, la portion identifiée est donc celle associés au couple $\left( P_i^H, P_j^V \right)$ maximum. Par exemple, la portion identifiée est celle dont la valeur $\left( P_i^H \right)^2 + \left( P_j^H \right)^2$ est maximale, ou qui est maximale au sens d'une distance ou d'une norme quelconque de $\Re^2$.

Avantageusement, le circuit électronique **44** met également en oeuvre d'autres traitements des tensions, par exemple le comptage du nombre d'impulsions produites depuis la mise en service des cordes, la détermination de l'intensité moyenne ou individuelle des impulsions, et/ou la détermination de la durée moyenne ou individuelle des impulsions, par exemple pour calculer la puissance des frappes de balle.

Pour l'alimentation en énergie électrique du circuit électronique **44,** une batterie rechargeable **50** est logée dans le manque **14** et est rechargée au moyen d'un connecteur **52** logé à l'extrémité du manche **14,** d'une manière connue en soi de l'état de la technique. Le connecteur est par exemple un port USB permettant d'une part la recharge d'une batterie et d'autre part la récupération de données stockées dans le circuit **44** à l'aide par exemple d'une clef USB ou d'un branchement à un ordinateur personnel.

En variante, ou de manière supplémentaire, le circuit électronique **44** comporte également un circuit d'alimentation électrique qui traite les tensions reçues à des fins de stockage et recharge grâce aux tensions traitées un élément de stockage d'énergie électrique. Notamment, l'élément de stockage d'énergie électrique est avantageusement constitué d'une micro-batterie formée sur un substrat souple ou rigide. Par exemple, l'élément de stockage est une micro-batterie à substrat rigide de la gamme « EnerChip » de la société Cymbet® Corp., par exemple une micro-batterie de référence « CBC050-M8C » d'une surface de 8x8 mm$^2$ pour une capacité de 50 μAh, ou bien une micro-batterie à substrat souple de la société Solicore®, Inc., par exemple un micro-batterie de référence « SF-2529-10EC » d'une surface pliable de 25,75x29 mm$^2$ pour une capacité de 10 mAh. En variante, l'élément de stockage d'énergie électrique comprend une ou plusieurs capacités et/ou un ou plusieurs supercapacités. Un tel circuit de stockage d'énergie permet notamment d'obtenir une raquette autonome en énergie et/ou de prolonger de manière notable la durée d'utilisation de celle-ci lorsqu'une batterie rechargeable est prévue.

En se référant à la figure 9, pour réaliser une reprise de contact entre une zone piézoélectrique d'une corde **18, 20** et les connexions électriques **42,** une portion de la corde disposée sur le cadre **12,** et de préférence en partie basse du cadre **12** de manière à minimiser la longueur des connexions électriques **42,** est dénudée de la couche externe protectrice de manière à accéder à la deuxième couche métallique **38.**

Comme cela est illustré sur la partie droite de la figure **9,** les connexions électriques **42** comprennent par exemple un fil conducteur **54** pour chaque zone piézoélectrique, constitué d'une âme métallique gainée d'un matériau isolant. Le fil **54** est dénudé à une extrémité et soudé à la portion libre de la deuxième couche métallique **34,** le fil **54** s'étendant pour l'essentiel sur ou dans le cadre **12** jusqu'au circuit électronique **44.** De préférence, le fils **54** sort du cadre par une ouverture **22** pour être connecté à la corde.

De nombreuses variantes pour la reprise de contact sont possibles. Par exemple, comme cela est illustré à la partie gauche de la figure 9, un tube métallique **56** est inséré dans une ouverture **22,** par exemple en remplacement d'un tube en caoutchouc usuellement inséré dans les ouvertures du cadre. En raison de la tension de la corde, on constate que cette dernière est généralement plaquée sur une portion du tube métallique de sorte que la portion de deuxième couche métallique **38** est au contact de ce dernier. Les dimensions du tube **56** pouvant en outre être choisies pour garantir un tel contact. Un fil **56,** tel que décrit précédemment, est alors par exemple prévu dans ou sur le cadre **12** en contact avec le tube **56.**

De préférence, la reprise de contact avec la première couche électrique **34** de chaque corde est réalisée au niveau d'un noeud **60** de celle-ci, tel qu'illustré à la figure **10.** L'extrémité de la corde est dénudée jusqu'à la première couche métallique **34** et un fil **62,** également dénudé à une extrémité et logé dans le cadre **12,** sort de ce dernier par l'ouverture **22** du cadre qui est au contact du noeud **60** et est soudé à la couche **34** de la corde.

Au total, les connexions électriques comprennent donc un nombre de fils égal à deux plus le nombre total de zones piézoélectriques, soit un total de fils égal à 8 dans le mode de réalisation décrit.

Il a été décrit un mode de réalisation particulier de l'invention. De nombreuses variantes peuvent y être apportées, par exemple celles-décrites ci-dessous, prises seules ou en combinaison.

Il a été décrit trois zones piézoélectriques par corde. Bien entendu, leur nombre peut être plus élevé pour augmenter la précision de la localisation de la frappe d'une balle sur le cordage. De même, le nombre de zones peut être différent d'une corde à l'autre.

Il a été décrit des zones piézoélectriques de longueur sensiblement égale. En variante, leurs longueurs ne sont pas égales, ce qui permet par exemple d'obtenir une précision variable de la localisation des impacts sur le cordage.

De même, il a été décrit deux cordes. Un nombre plus important de cordes peut être prévu.

Il a été également décrit un circuit électronique qui intègre l'ensemble des modules de calcul en vue de caractériser les frappes de balle (position, comptage, calcul de la puissance, etc). En variante, tout ou partie de ces fonctions sont mises en oeuvre hors de la raquette de manière additionnelle au circuit ou en lieu et place de ce dernier. Le circuit électronique est alors configuré pour transmettre les tensions numérisées hors de la raquette, par exemple au moyen de sa connexion sans fil.

De manière optionnelle, le circuit électronique est également prévu pour tester l'état d'usure du cordage. Notamment, comme cela est connu en soi, lorsqu'un courant électrique est injecté dans un matériau piézoélectrique, ce dernier vibre. Le circuit électronique est ainsi avantageusement configuré pour soumettre, via les connexions électriques, une partie ou la totalité des zones piézoélectriques à des tensions non nulles afin de faire vibrer les cordes, la résistance des cordes aux vibrations permettant de connaître l'état d'usure de celles-ci.

Il a été décrit une raquette de tennis. Bien évidemment l'invention s'applique à tout type de raquette à cordage, par exemple les raquettes de badminton ou de squash.

## Revendications

**1.** Système comprenant une raquette (10) ayant un manche (14), un cadre (12) fixé au manche (14) et un cordage (18, 20) comprenant au moins deux cordes perpendiculaires tendues dans le cadre (12), chaque corde (18, 20) réalisant des allers-retours dans le cadre (12) en passant par des ouvertures (22) formées dans celui-ci, *caractérisé* **en ce que** le système comporte:

- pour chaque corde (18, 20), une gaine piézoélectrique (24) enrobant ladite corde (18, 20) sur l'essentiel de sa longueur, ladite gaine (24) étant divisée sur sa longueur en au moins trois zones piézoélectriques (28, 30, 32) comprenant chacune une couche piézoélectrique (36) intercalée entre deux couches conductrices (34, 38) formant respectivement une première et une seconde électrodes, la couche piézoélectrique (36) et au moins l'une des électrodes (38) de chaque zone piézoélectrique formant un ensemble électriquement isolé des couches piézoélectriques (36) et des électrodes (36, 38) des autres zones piézoélectriques de sorte que chaque zone piézoélectrique génère entre ses électrodes une tension indépendante en fonction de contraintes mécaniques exercées sur le cordage ; et
- un circuit électronique (44) connecté aux zones piézoélectriques (28, 30, 32) des cordes (18, 20) pour identifier une portion du cordage subissant les plus fortes contraintes mécaniques en fonction des tensions générées par les zones piézoélectriques des cordes.

**2.** Système selon la revendication 1, *caractérisé* **en ce que** la gaine (24) de chaque corde (18, 20) comprend :

- une première couche (34) continue et électriquement conductrice, formée sur l'essentiel de la longueur de la corde (18, 20), la première couche (24) constituant la première électrode de chaque zone piézoélectrique de la corde ;
- au moins trois portions de couche piézoélectrique (36), déposées sur la première couche (34) ; et
- des secondes couches (38) électriquement conductrices distinctes, déposées respectivement sur les couches piézoélectriques (36) et formant respectivement les secondes électrodes des zones piézoélectriques.

**3.** Système selon la revendication 1 ou 2, *caractérisé* **en ce que** la gaine (24) de chaque corde (18, 20) comprend une couche externe (40) de protection électriquement isolante.

**4.** Système selon la revendication 3, *caractérisé* **en ce que** la couche externe (40) est partiellement dénudée sur une portion en regard de chaque zone piézoélectrique (28, 30, 32) de la corde (18, 20), ladite portion dénudée étant sur le cadre (12), de manière à libérer une portion une portion de la seconde couche de ladite zone.

**5.** Système selon la revendication 4, *caractérisé en ce qu'*il comprend des connexions électriques (42) agencées sur ou dans le cadre et soudées respectivement aux portions libérées des secondes couches (38) de manière à collecter la tension générée par ladite zone.

**6.** Système selon la revendication 5, *caractérisé en ce que* les connexions électriques se prolongent dans le manche, et **en ce que** le circuit électronique est au moins partiellement logé dans le manche et est connecté aux connexions électriques.

**7.** Système selon l'une quelconque des revendications précédentes, *caractérisé* **en ce que** le circuit électronique est entièrement compris dans le manche.

**8.** Système selon la revendication 7, *caractérisé en ce que* le circuit électronique comprend une mémoire informatique pour stocker des informations relatives aux portions de cordage identifiées et un circuit d'émission sans fil connecté à ladite mémoire pour transmettre par une liaison de communication sans fil lesdites informations à l'extérieur du manche.

**9.** Système selon l'une quelconque des revendications précédentes, *caractérisé* **en ce que** le circuit électronique comporte un élément de stockage d'énergie électrique pour stocker l'énergie électrique générées par les zones piézoélectriques.

**10.** Système selon la revendication 9, *caractérisé en ce que* l'élément de stockage de l'énergie électrique comporte une micro-batterie formée sur un substrat souple ou rigide et/ou une capacité et/ou une supercapacité ou piles boutons.

**Patentansprüche**

**1.** System bestehend aus einem Schläger (10) mit einem Griff (14), einem Rahmen (12), welcher am Griff (14) befestigt ist, sowie ein Saitenmaterial (18, 20), umfassend mindestens zwei Saiten, die im Rahmen (12) im rechten Winkel zueinander gespannt sind, wo jede Saite (18, 20) mehrmals im Rahmen (12) durch die darin gebildeten Öffnungen (22) hin- und hergeführt werden, **dadurch gekennzeichnet, dass** das System folgendes umfasst:

- für jede Saite (18, 20) eine piezoelektrische Umhüllung (24), welche die besagte Saite (18, 20) über den wesentlichen Teil ihrer Länge umhüllt, wobei die besagte Umhüllung (24) über die gesamte Länge in mindestens drei piezoelektrische Bereiche (28, 30, 32) unterteilt ist, wo jeder eine piezoelektrische Schicht (36) umfasst, die zwischen zwei leitfähigen Schichten (34, 38) eingefügt ist, und respektive eine erste und eine zweite Elektrode bildet, wo die piezoelektrische Schicht (36) und mindestens eine der Elektroden (38) aus jedem piezoelektrischen Bereich eine elektrisch isolierte Einheit bilden, die von den piezoelektrischen Schichten (36) und den Elektroden (36, 38) der anderen piezoelektrischen Bereiche isoliert ist, derart, dass jeder piezoelektrische Bereich zwischen seinen Elektroden, je nach der auf seinen Saiten ausgeübten mechanischen Belastung eine unabhängige Spannung erzeugt; und
- einen elektronischen Schaltkreis (44), der an die piezoelektrischen Bereiche (28, 30, 32) der Saiten (18, 20) angeschlossen ist, um einen Abschnitt der Saiten zu definieren, der gemäß der von den piezoelektrischen Bereichen der Saiten generierten Spannung die stärkste mechanische Beanspruchung aufweist.

**2.** System gemäß Anspruch 1, **dadurch gekennzeichnet, dass** die Umhüllung (24) einer jeden Saite (18, 20) folgendes umfasst:

- eine erste kontinuierliche und elektrisch leitfähige Schicht (34), die über einen wesentlichen Teil der Saite (18, 20) gebildet ist, wobei die erste Schicht (24) die erste Elektrode eines jeden piezoelektrischen Bereichs der Saite bildet; mindestens drei Abschnitte einer piezoelektrischen Schicht (36), die auf der ersten Schicht (34) aufgetragen werden, und
- zweite, getrennt elektrisch leitfähige Schichten (38), die respektive auf die piezoelektrischen Schichten (36) aufgetragen werden und respektive die zweiten Elektroden der piezoelektrischen Schichten bilden.

**3.** System gemäß Anspruch 1 oder 2, **dadurch gekennzeichnet, dass** die Umhüllung (24) einer jeden Saite (18, 20) eine elektrisch isolierende externe Schutzschicht (40) umfasst.

**4.** System gemäß Anspruch 3, **dadurch gekennzeichnet, dass** die Außenschicht (40) teilweise in einem Abschnitt gegenüber eines jeden der piezoelektrischen Bereiche (28, 30, 32) der Saite (18, 20) abisoliert ist, wobei der abisolierte Abschnitt auf dem Rahmen (12) befindlich ist, derart, dass ein Abschnitt der zweiten Schicht des besagten Bereichs freigesetzt wird.

**5.** System gemäß Anspruch 4, **dadurch gekennzeichnet, dass** es elektrische Anschlüsse (42) umfasst, die auf oder in dem Rahmen angeordnet und respektive an den abisolierten Abschnitten der zweiten Schichten (38) angeschweißt sind, um die im besagten Bereich generierte Spannung zu sammeln

**6.** System gemäß Anspruch 5, **dadurch gekennzeichnet, dass** die elektrischen Anschlüsse in der Umhüllung verlängert werden, und dass der elektronische Schaltkreis mindestens teilweise im Griff untergebracht und an den elektrischen Anschlüssen angeschlossen ist.

**7.** System gemäß einem beliebigen der vorstehenden Ansprüche, **dadurch gekennzeichnet, dass** der elektronische Schaltkreis gänzlich in den Griff integriert ist.

**8.** System gemäß Anspruch 7, **dadurch gekennzeichnet, dass** der elektronische Schaltkreis einen Computerspeicher umfasst, um die Informationen in Bezug auf die identifizierten Saitenabschnitte zu speichern, sowie einen drahtlosen Emissionskreislauf, der an besagten Speicher angeschlossen ist, um über eine drahtlose Kommunikationsverbindung die besagten Informationen ins Äußere des Griffs zu übermitteln.

**9.** System gemäß einem beliebigen der vorstehenden Ansprüche, **dadurch gekennzeichnet, dass** der elektronische Schaltkreis ein Energie-Speicherelement umfasst, zum Speichern der von den piezoelektrischen Bereichen generierten elektrischen Energie.

**10.** System gemäß Anspruch 9, **dadurch gekennzeichnet, dass** das Energie-Speicherelement für die elektrische Energie eine Mikrobatterie umfasst, die auf einem elastischen oder starren Substrat gebildet wird und/oder eine Kapazität und/oder eine Superkapazität oder Knopfbatterien.

**Claims**

**1.** A system comprising a racket (10) having a handle (14), a frame (12) attached to the handle (14), and strings (18, 20) comprising at least two perpendicular strings stretched in the frame (12), each string (18, 20) running back and forth in the frame (12) through openings (22) formed therein, **characterized in that** the system comprises:

- for each string (18, 20), a piezoelectric sheath (24) coating said string (18, 20) along most of its length, said sheath (24) being divided along its length into at least three piezoelectric areas (28, 30, 32), each comprising a piezoelectric layer (36) interposed between two conductive layers (34, 38) respectively forming a first and a second electrodes, the piezoelectric layer (36) and at least one of the electrodes (38) of each piezoelectric area forming an assembly electrically insulated from the piezoelectric layers (36) and the electrodes (36, 38) of the other piezoelectric layers so that each piezoelectric area generates between its electrodes an independent voltage according to mechanical stress exerted on the strings; and
- an electronic circuit (44) connected to the piezoelectric areas (28, 30, 32) of the strings (18, 20) to identify a portion of the strings submitted to the highest mechanical stress according to the voltages generated by the piezoelectric areas of the strings.

**2.** The system of claim 1, **characterized in that** the sheath (24) of each string (18, 20) comprises:

- a first electrically-conductive continuous layer (34) formed along most of the length of the string (18, 20), the first layer (24) forming the first electrode of each piezoelectric area of the string;
- at least three piezoelectric layer portions (36), deposited on the first layer (34); and
- second different electrically-conductive layers (38), respectively deposited on the piezoelectric layers (36) and respectively forming the second electrodes of the piezoelectric areas.

**3.** The system of claim 1 or 2, **characterized in that** the sheath (24) of each string (18, 20) comprises an electrically-insulating external protection layer (40).

**4.** The system of claim 3, **characterized in that** the external layer (40) is partially stripped along a portion opposite each piezoelectric area (28, 30, 32) of the string (18, 20), said stripped portion being on the frame (12), to expose a portion of the second layer of said area.

**5.** The system of claim 4, **characterized in that** it comprises electric connections (42) arranged on or inside of the frame and respectively welded to the exposed portions of the second layers (38) to collect the voltage generated by said area.

**6.** The system of claim 5, **characterized in that** the electric connections continue inside of the handle, and the electronic circuit is at least partially housed within the handle and is connected to the electric connections.

**7.** The system of any of the foregoing claims, **characterized in that** the electronic circuit is entirely contained within the handle.

**8.** The system of claim 7, **characterized in that** the electronic circuit comprises a computer memory for storing data relative to the identified string portions and a wireless transmission circuit connected to said memory to transmit over a wireless communication link said data outside of the handle.

9. The system of any of the foregoing claims, *characterized in that* the electronic circuit comprises an electric power storage element for storing the electric power generated by the piezoelectric areas.

10. The system of claim 9, *characterized in that* the electric power storage element comprises a microbattery formed on a flexible or rigid substrate and/or a capacitor and/or a supercapacitor or button cells.

**Fig. 1**

**Fig. 2**

Fig. 3

Fig. 4    Fig. 5

Fig. 6    Fig. 7

**Fig. 9**

**Fig. 8**

**Fig. 10**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4257594 A